# EUROPÄISCHE PATENTSCHRIFT

(11) **EP 1 154 565 B1**
(45) Veröffentlichungstag und Bekanntmachung des Hinweises auf die Patenterteilung: **18.11.2009**
(21) Anmeldenummer: 01109054.5
(22) Anmeldetag: 11.04.2001
(51) Int. Cl.: H03F 1/30

(54) **Verstärkerschaltung mit Offset-Kompensation, insbesondere für digitale Modulationseinrichtungen**
Amplifying circuit for offset compensation, in particular for digital modulation apparatuses
Circuit amplificateur pour la compensation de décalage, en particulier pour des appareils de modulation digitale

(30) Priorität: 11.05.2000 DE 10023114
(43) Veröffentlichungstag der Anmeldung: 14.11.2001
(73) Patentinhaber: Infineon Technologies AG, 85579 Neubiberg (DE)
(72) Erfinder: Isken, Martin, 89233 Neu-Ulm (DE); Schmal, Josef, 81547 München (DE); Memmler, Bernd, 85521 Ottobrun (DE); Tränkle, Günther, 89233 Neu-Ulm (DE)
(74) Vertreter: Viering, Jentschura & Partner

(56) Entgegenhaltungen:
- EP-A- 0 178 044
- EP-A- 0 721 099
- US-A- 4 229 703
- US-A- 4 395 681
- US-A- 4 490 682
- US-A- 5 606 320
- US-A- 6 054 887
- KAYAL M ET AL: "An automatic offset compensation technique applicable to existing operational amplifier core cell" CUSTOM INTEGRATED CIRCUITS CONFERENCE, 1998. PROCEEDINGS OF THE IEEE 1998 SANTA CLARA, CA, USA 11-14 MAY 1998, NEW YORK, NY, USA,IEEE, US, 11. Mai 1998 (1998-05-11), Seiten 419-422, XP010293983 ISBN: 0-7803-4292-5

## Beschreibung

Die Erfindung betrifft eine Verstärkerschaltung mit Offsetkompensation, insbesondere für digitale Modulationseinrichtungen, mit einem Differenzverstärker und einem Regelkreis mit einer Regelschaltung, die von einer Offsetspannung des Differenzverstärkers gesteuert wird, und die ein Offset-Kompensationssignal in den Differenzverstärker einspeist.

Normalerweise treten bei integrierten differentiellen Verstärkern Offsetspannungen am Ausgang auf. Diese Offsetspannungen können beispielsweise durch Fertigungstoleranzen bedingt sein, welche die Symmetrie des Schaltungsaufbaus in negativer Weise beeinflussen können. Andere mögliche Ursachen für Offsetspannungen an Ausgängen von Differenzverstärkern sind Fehlanpassungen der integrierten Bauelemente oder, bei DCR- (Direct Conversion Receiver-) Architekturen von Hochfrequenz-Empfängern Selbstmischeffekte.

In Empfangspfaden von Hochfrequenz-Empfängern, wie sie beispielsweise in Mobilfunkanwendungen in großer Zahl eingesetzt werden, sind Differenzverstärkern oder Mischer-Stufen, welche ausgangsseitige Gleichspannungs-Offsets aufweisen können, normalerweise Analog/Digital-Wandler nachgeschaltet, wodurch eine digitale Weiterverarbeitung der Daten- oder Sprachsignale im Basisband möglich ist. Weist das den AD-Wandlern zugeführte Signal jedoch einen Gleichspannungs-Offset auf, so können die Wandler, welche einen begrenzten Aussteuerbereich haben, übersteuert werden.

Es ist bekannt, Gleichspannungs-Offsets dadurch zu kompensieren, daß eine kapazitive Kopplung zur nachfolgenden Stufe vorgesehen ist. Wenn die Frequenz des Nutzsignals aber gering ist, sind die erforderlichen Koppelkapazitäten für eine Integration zu groß und zu teuer.

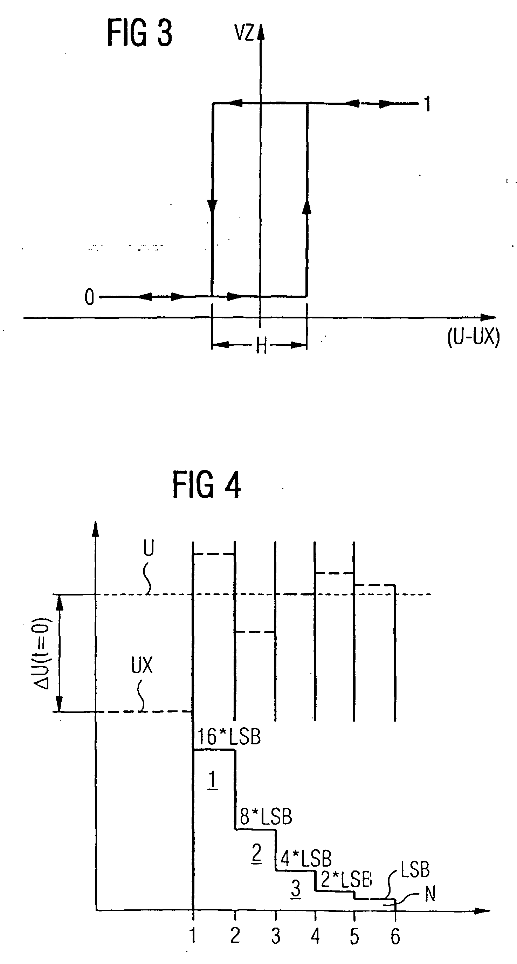

In dem Dokument Kayal et al.: "An automatic offset compensation technique applicable to existing operational amplifier core cell", Custom Integrated Circuits Conference, 1998, Proceedings of the IEEE 1998, Seiten 419-422, ist ein zweistufiger Operationsverstärker mit automatischer OffsetKompensation angegeben. Ein Komparator und ein Digital/Analog-Konverter sind einem Register für sukzessive Approximation zugeordnet, wie dort anhand Figur 3 gezeigt.

Aus dem Dokument EP 0 693 823 A1 ist eine gattungsgemäße Verstärkerschaltung mit einer analogen Offsetkompensation von Gleichspannungs-Offsets bekannt. Über einen Operationsverstärker wird dort die Offsetspannung einem Kondensator, welcher extern vorgesehen ist, zugeführt. Ein Vergleich von Kondensatorspannung und einer Referenzspannung ermöglicht eine Erzeugung von Kompensationsströmen, die der Offsetspannung entgegenwirken.

Diese bekannte Offsetkompensation weist den Nachteil auf, daß durch Nichtidealitäten in Kapazität oder IC Leckströme fließen können, wodurch die an der Kapazität anliegende Spannung einem zeitlichen Drift unterworfen ist. Hierdurch kann die Offsetkompensation verfälscht werden. Folglich darf die Kapazität nicht zu klein gewählt werden. Zudem können zu große Lade- oder Entladeströme zu Instabilitäten in der Regelung führen.

Aufgabe der vorliegenden Erfindung ist es, die gattungsgemäße Verstärkerschaltung so weiterzubilden, daß eine driftfreie Offsetkompensation, die einen schnellen Abgleich ermöglicht, realisiert ist.

Die Aufgabe wird erfindungsgemäß mit einer Verstärkerschaltung gemäß Patentanspruch 1 gelöst, bei der der Regelkreis eine digitale Stelleinrichtung aufweist.

Die Realisierung der Verstärkerschaltung mit einer digitalen Stelleinrichtung im Regelkreis hat den Vorteil, daß durch den Wegfall einer externen Speicherkapazität und damit verbundener Zeitkonstanten eine sehr schnelle, driftfreie Kompensation eines Gleichspannungsoffsets möglich ist. Außerdem kann die Kompensation sehr schnell erfolgen, da die Dauer nur noch von der Einschwingzeit des Differenzverstärkers abhängt.

Weitere Vorteile ergeben sich durch die Möglichkeit der chipinternen Integration der digitalen Stelleinrichtung, wodurch ein Anschluß-Pin entfallen kann. Außerdem muß bei einem Schaltungsentwurf nicht auf eine Verringerung von Leckströmen, welche die Kapazität entladen könnten, geachtet werden. Der digitalen Stelleinrichtung ist die Offsetspannung zuführbar. In der digitalen Stelleinrichtung ist ein Offset-Kompensationssignal bildbar, welches in den Differenzverstärker eingespeist werden kann.

In einer vorteilhaften Ausführungsform der vorliegenden Erfindung ist ein Vergleicher zur Bereitstellung des Vorzeichens der Offsetspannung ausgangsseitig an den Differenzverstärker angeschlossen.

In einer weiteren, vorteilhaften Ausführungsform der vorliegenden Erfindung ist die Stelleinrichtung mit dem Vergleicher zur Zuführung des Vorzeichens der Offsetspannung verbunden. Hierdurch ergibt sich ein besonders einfacher Schaltungsaufbau, da der digitalen Stelleinrichtung lediglich das Vorzeichen der Offsetspannung, welches in einem Bit binär codiert sein kann, zugeführt wird.

In einer weiteren, vorteilhaften Ausführungsform der vorliegenden Erfindung weist die Stelleinrichtung eine Stelleinheit mit nachgeschaltetem Digital/Analog-Wandler auf.

In einer weiteren, vorteilhaften Ausführungsform der vorliegenden Erfindung sind Stelleinheit und Digital/Analog-Wandler mit einer Wortleitung zur Übertragung einer Stellgröße verbunden.

In einer weiteren, vorteilhaften Ausführungsform der vorliegenden Erfindung weist die Stelleinheit ein Register zur Speicherung eines digital codierten Offset-Kompensationswertes auf.

In einer weiteren, vorteilhaften Ausführungsform der vorliegenden Erfindung weist der Digital/Analog-Wandler Stromquellen auf. Hierdurch können Kompensationsströme erzeugt werden, welche dem Differenzverstärker zuführbar sind, und die der Offsetspannung entgegenwirken.

In einer weiteren, vorteilhaften Ausführungsform der vorliegenden Erfindung weist der Vergleicher eine Hysterese auf, die die Abhängigkeit des ausgangsseitigen Vorzeichens von der eingangsseitigen Offsetspannung beschreibt, wobei die Hysterese vorteilhafterweise kleiner als die minimal auszugleichende Offsetspannung ist. Hierdurch kann in zuverlässiger Weise jeder eingangsseitig am Vergleicher anliegenden Offsetspannung ein Vorzeichen, welches binär codiert sein kann, zugeordnet werden. Einem positiven Vorzeichen kann beispielsweise eine logische 1, einem negativen Vorzeichen eine logische 0 zugeordnet werden. Die Zuordnung der logischen Pegel kann auch umgekehrt erfolgen.

Schließlich kann in einer vorteilhaften Ausführungsform der vorliegenden Erfindung der Regelkreis eine Steuereinheit zur Bildung des Offset-Kompensationssignals mit sukzessiver Approximation aufweisen. Das Verfahren der sukzessiven Approximation wird auch als Wägeverfahren bezeichnet. Bei einer Analog/Digital-Umsetzung nach dem Wägeverfahren wird, ausgehend vom höchsten Bit (MSB, Most Significant Bit) bis hin zum niederwertigsten Bit (LSB, Least Significant Bit) jeweils ein Bit gesetzt und anschließend geprüft, ob bei einem Vergleich von einem Soll- und einem Istwert ein Vorzeichenwechsel vorliegt. Ist das der Fall, so wird das Bit zurückgenommen. Wenn nicht, bleibt das Bit gesetzt. In jedem Fall wird anschließend das nächstniedrigere Bit gesetzt und wieder ein Soll-mit einem Istwert verglichen. Dieser Wägevorgang wird solange wiederholt, bis auch das niedrigste Bit feststeht. Da bei vorliegender Anordnung das Vorzeichen der Offsetspannung aus einem Differenzsignal abgeleitet werden kann, ist kein Soll-oder Referenzsignal zur Bildung des Vorzeichens erforderlich.

Weitere Einzelheiten der Erfindung sind in den Unteransprüchen angegeben.

Die Erfindung wird nachfolgend an einem Ausführungsbeispiel anhand der Zeichnungen näher erläutert.

Es zeigen:
- Figur 1: ein Prinzipschaltbild eines ersten Ausführungsbeispiels der erfindungsgemäßen Verstärkerschaltung,
- Figur 2: ein Detail-Schaltbild des Digital/Analog-Wandlers aus Figur 1,
- Figur 3: die Hysterese des Vergleichers aus Figur 1, und
- Figur 4: einen Ablauf eines Abgleichvorgangs mit einer Verstärkerschaltung gemäß Figur 1.

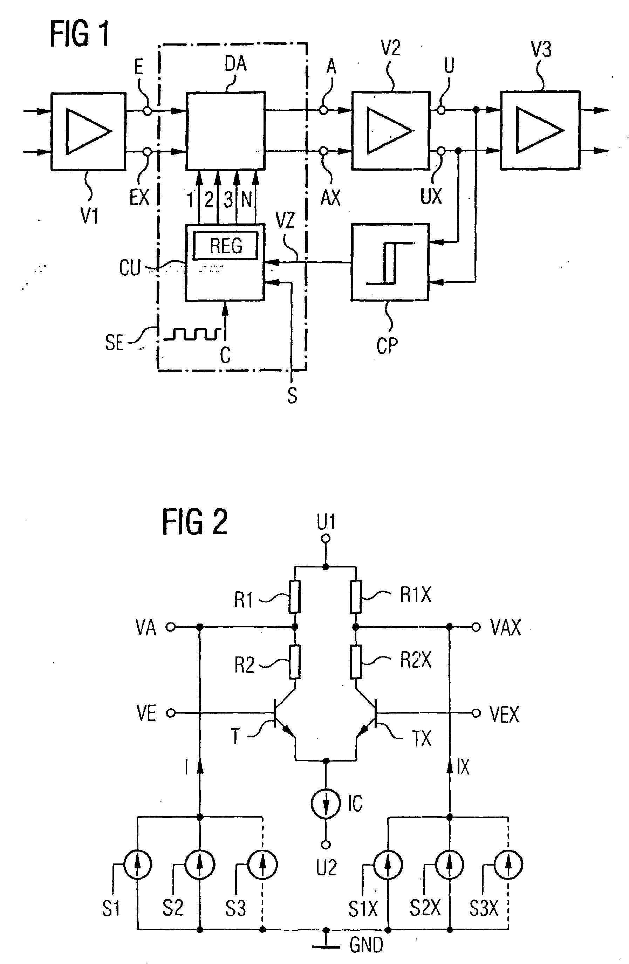

Figur 1 zeigt einen Eingangsverstärker V1, an den ausgangsseitig ein Differenzverstärker V2 angeschlossen ist, dem ein Ausgangsverstärker V3 nachgeschaltet ist. Die Verstärker V1, V2, V3 sind als Differenzverstärker ausgebildet. Dem Differenzverstärker V2 ist weiterhin ein Vergleicher CP nachgeschaltet, der an eine digitale Stelleinrichtung SE angeschlossen ist. Die digitale Stelleinrichtung SE weist eine Steuereinheit CU mit einem Register REG auf. An die Steuereinheit CU ist ein Digital/Analog-Wandler DA mit zwei Eingängen E, EX und zwei Ausgängen A, AX angeschlossen, der zwischen Eingangsverstärker V1 und Differenzverstärker V2 geschaltet ist.

Der Differenzverstärker V2 kann ausgangsseitig einen Offset aufweisen. Der Komparator CP, der an die beiden differentiellen Ausgänge U, UX des Differenzverstärkers angeschlossen ist, vergleicht die Spannung U an einem Ausgang des Differenzverstärkers mit der Spannung UX am anderen Ausgang des Differenzverstärkers V2. Dieses Vorzeichen der Offsetspannung VZ steht ausgangsseitig am Komparator CP zur Verfügung. Eine digitale Stelleinrichtung SE ist an den Komparator CP, der, falls die Spannung an der ersten Ausgangsklemme U des Differenzverstärkers größer als die Spannung UX an der zweiten Ausgangsklemme des Differenzverstärkers ist, eine logische 1, und andernfalls eine logische 0 zur Verfügung stellt, angeschlossen. Die Stelleinrichtung SE weist eine Steuereinheit CU und einen Digital/Analog-Wandler DA auf, welche über eine N-Bit-Wortleitung 1, 2, 3, N miteinander verbunden sind. Der Steuereinheit CU sind neben dem Vorzeichen VZ ein Taktsignal C und ein Startsignal S zuführbar. Die Steuereinheit CU weist ein Register REG zur Speicherung des digital codierten Kompensationswerts auf. Das N-Bit-Kompensationssignal ist dem Digital/Analog-Wandler DA zuführbar, der in Abhängigkeit vom Offset-Kompensationssignal Kompensationsströme erzeugt, welche der Offsetspannung am Differenzverstärker entgegenwirken. Hierzu kann der Digital/Analog-Wandler DA Stromquellen aufweisen.

Die Schaltung gemäß Figur 1 kann mit dem Verfahren der sukzessiven Approximation, auch Wägeverfahren genannt, betrieben werden. Gegenüber dem üblicherweise bekannten Wägeverfahren ist bei vorliegender Verstärkerschaltung jedoch kein Abtast-Halte-Glied zur Speicherung eines Referenzwertes erforderlich. Wenn das offsetbehaftete Signal am Ausgang des Differenzverstärkers V2 als Differenzsignal U, UX vorliegt, kann das Vorzeichen VZ unmittelbar durch Bilden der Differenzspannung ermittelt werden.

Die Bildung des richtigen Kompensationswerts und dessen Speicherung im Register REG wird durch Zuhilfenahme des Diagramms gemäß Figur 4 deutlich. Vor Beginn der Kompensation liegt ausgangsseitig am Differenzverstärker V2 eine Offsetspannung ΔU, welche sich aus der Differenz der Differenzsignalspannungen U, UX ergibt, vor. Zunächst wird in der Steuereinheit CU das höchstwertige Bit 1, welches dem 16-fachen Wert des niedrigsten Bits LSB entspricht, gesetzt. Im Digital/Analog-Wandler DA wird ein entsprechendes Kompensationssignal als Kompensationsstrom dem Differenzverstärker V2 zugeführt. In Abhängigkeit davon stellt sich am Ausgang des Differenzverstärkers V2 eine Offsetspannung ein, welche nunmehr ein anderes Vorzeichen als vor Beginn der Kompensation aufweist. Der Vergleicher CP detektiert den Vorzeichenwechsel. In der Steuereinheit CU wird folglich das zuletzt gesetzte Bit 1 zurückgenommen und das nächstniedrigere Bit 2 gesetzt. Dieses entspricht dem 8-fachen Wert des niedrigsten Bit LSB. Mit diesem neuen Kompensationswert werden wiederum entsprechende Kompensationsströme dem Differenzverstärker V2 zugeführt. Da der Vergleicher CP nun keinen Vorzeichenwechsel feststellt, bleibt das zuletzt gesetzte Bit gesetzt. Im nächsten Schritt wird wiederum das nächstniedrigere Bit gesetzt. Dieses Verfahren wird solange wiederholt, bis das niedrigstwertige Bit LSB feststeht. Das derart gebildete N-Bit-Kompensationssignal wird im Register REG digital und driftfrei gespeichert. Somit ist die ausgangsseitige Offsetspannung am Differenzverstärker V2 entweder 0 oder minimal. Dem Differenzverstärker V2 im Nutzsignalpfad nachgeschaltete Stufen, beispielsweise der Endverstärker V3, können offsetfrei betrieben werden. Dies ist besonders für im Basisbandbaustein vorhandene Analog/Digital-Wandler vorteilhaft, bei denen nunmehr eine Übersteuerung vermieden werden kann.

Figur 2 zeigt ein detaillierteres Ausführungsbeispiel für einen Digital/Analog-Wandler, wie er beispielsweise in dem Prinzipschaltbild gemäß Figur 1 zum Einsatz kommen kann. Es ist ein Differenzverstärker mit zwei Eingängen VE, VEX und zwei Ausgängen VA, VAX angegeben. Die Eingänge VE, VEX sind mit den Basisanschlüssen zweier emittergekoppelter Transistoren T, TX verbunden. Die Konstantstromquelle IC in der gemeinsamen Emitterleitung bewirkt, daß die Summe der Emitterströme konstant bleibt. An die Kollektoranschlüsse der Transistoren T, TX sind die Ausgänge des Differenzverstärkers VA, VAX über ein Widerstandsnetzwerk R1, R1X, R2, R2X, an die eine erste Versorgungsspannung U1 anschließbar ist, verbunden. Die Konstantstromquelle IC in der gemeinsamen Emitterleitung ist mit einem zweiten Versorgungsspannungsanschluß U2 verbunden. Die Ausgänge VA, VAX des Differenzverstärkers sind mit Stromquellen verbunden, welche auf die Kollektorwiderstände des Differenzverstärkers arbeiten. Die Stromquellen sind als schaltbare Stromquellen S1, S2, S3, S1X, S2X, S3X ausgeführt, die mit einer Masseklemme GND verbunden sind. Sie dienen zur Erzeugung von Kompensationsströmen I, IX, welche der Offsetspannung entgegenwirken. Die Kompensationsströme I, IX können in Abhängigkeit der zu kompensierenden Offsetspannung erzeugt werden. Vorteilhafterweise sind die Stromquellen binär abgestuft.

Figur 3 beschreibt die im Komparator CP gebildete Hysterese. In Abhängigkeit der an den Eingängen des Komparators CP anliegenden, differentiellen Spannungswerten U, UX des Differenzverstärkers V2 wird am Ausgang des Komparators CP entweder eine logische 0 oder eine logische 1 ausgegeben. Hierfür ist eine Hysterese H vorgesehen, so daß in allen Fällen eine zuverlässige Entscheidung im Komparator CP getroffen werden kann. In vorteilhafter Weise sollte diese Hysterese H kleiner als der zumindest auszugleichende Offsetspannungswert am Differenzverstärker V2 sein.

## Patentansprüche

1. Verstärkerschaltung mit Offsetkompensation, insbesondere für digitale Modulationseinrichtungen, mit einem Differenzverstärker (V2) und einem Regelkreis (V2, CP, CU, DA) mit einer Regelschaltung (CP, CU, DA), die von einer Offsetspannung des Differenzverstärkers (V2) gesteuert wird, und die ein Offset-Kompensationssignal in den Differenzverstärker (V2) einspeist,
**dadurch gekennzeichnet, daß**
der Regelkreis eine digitale Stelleinrichtung (SE, CU, DA) aufweist, und ein Vergleicher (CP) zur Bereitstellung des Vorzeichens (VZ) der Offsetspannung an zwei differentielle Ausgänge (U, UX) des Differenzverstärkers (V2) angeschlossen ist.

2. Verstärkerschaltung nach Anspruch 1,
**dadurch gekennzeichnet, daß**
die Stelleinrichtung (SE) mit dem Vergleicher (CP) zur Zuführung des Vorzeichens (VZ) der Offsetspannung verbunden ist.

3. Verstärkerschaltung nach Anspruch 1 oder 2,
**dadurch gekennzeichnet, daß**
die Stelleinrichtung (SE) eine Steuereinheit (CU) mit nachgeschaltetem Digital/Analog-Wandler (DA) aufweist.

4. Verstärkerschaltung nach Anspruch 3,
**dadurch gekennzeichnet, daß**
Stelleinrichtung (SE) und Digital/Analog-Wandler (DA) mit einer Wortleitung zur Übertragung einer Stellgröße verbunden sind.

5. Verstärkerschaltung nach Anspruch 3 oder 4,
**dadurch gekennzeichnet, daß**
die Stelleinrichtung (SE) ein Register (REG) zur Speicherung eines digital codierten Offset-Kompensationswerts aufweist.

6. Verstärkerschaltung nach einem der Ansprüche 3 bis 5,
**dadurch gekennzeichnet, daß**
der Digital/Analog-Wandler Stromquellen (S1, S2, S3, S1X, S2X, S3X) aufweist.

7. Verstärkerschaltung nach einem der Ansprüche 1 bis 6,
**dadurch gekennzeichnet, daß**
der Vergleicher (CP) eine Hysterese (H) aufweist, die die Abhängigkeit des ausgangsseitigen Vorzeichens (VZ) von der eingangsseitigen Offsetspannung (U, UX) beschreibt.

8. Verstärkerschaltung nach einem der Ansprüche 1 bis 7,
**dadurch gekennzeichnet, daß**
der Regelkreis eine Steuereinheit (CU) zur Bildung des Offset-Kompensationssignals mit sukzessiver Approximation aufweist.

## Claims

1. Amplifier circuit with offset compensation, in particular for digital modulation devices, with a differential amplifier (V2) and a control loop (V2, CP, CU, DA) with a control circuit (CP, CU, DA), which is controlled by an offset voltage of the differential amplifier (V2), and which feeds in an offset compensation signal in the differential amplifier (V2),
**characterized in that** the control loop comprises a digital setting device (SE, CU, DA), and a comparator (CP) for the provision of the algebraic sign (VZ) of the offset voltage is connected to two differential outputs (U, UX) of the differential amplifier (V2).

2. Amplifier circuit according to claim 1,
**characterized in that** the setting device (SE) is connected with the comparator (CP) for supplying of the algebraic sign (VZ) of the offset voltage.

3. Amplifier circuit according to claim 1 or 2,
**characterized in that** the setting device (SE) comprises a control unit (CU) with a digital/analog converter (DA) connected downstream thereof.

4. Amplifier circuit according to claim 3,
**characterized in that** setting device (SE) and digital/analog converter (DA) are connected with a word line for transmission of a regulating variable.

5. Amplifier circuit according to claim 3 or 4,
**characterized in that** the setting device (SE) comprises a register (REG) for storage of a digitally coded offset compensation value.

6. Amplifier circuit according to one of the claims 3 to 5,
**characterized in that** the digital/analog converter comprises current sources (S1, S2, S3, S1X, S2X, S3X).

7. Amplifier circuit according to one of the claims 1 to 6,
**characterized in that** the comparator (CP) exhibits a hysteresis (H), which describes the dependence of the algebraic sign (VZ) at the output side on the offset voltage (U, UX) at the input side.

8. Amplifier circuit according to one of the claims 1 to 7,
**characterized in that** the control loop comprises a control unit (CU) for the generation of the offset compensation signal with successive approximation.

## Revendications

1. Circuit amplificateur à compensation du décalage, notamment pour des dispositifs numériques de modulation, comprenant un amplificateur (V2) différentiel et un circuit (V2, CP, CU, DA) de régulation ayant un montage (CP, CU, DA) de régulation, qui est commandé par une tension de décalage de l'amplificateur (V2) différentiel et qui envoie un signal de compensation de décalage à l'amplificateur (V2) différentiel,
**caractérisé en ce que**
le circuit de régulation a un dispositif (SE, CU, DA) numérique de réglage, et un comparateur (CP) de mise à disposition du signe (VZ) de la tension de décalage est raccordé à deux sorties (U, UX) différentielles de l'amplificateur (V2) différentiel.

2. Circuit amplificateur suivant la revendication 1, **caractérisé en ce que**
le dispositif (SE) de réglage est relié au comparateur (CP) pour envoyer le signe (VZ) de la tension de décalage.

3. Circuit amplificateur suivant la revendication 1 ou 2,
**caractérisé en ce que**
le dispositif (SE) de réglage a une unité (CU) de commande, ayant un convertisseur (DA) numérique/analogique en aval.

4. Circuit amplificateur suivant la revendication 3,
**caractérisé en ce que**
le dispositif (SE) de réglage et le convertisseur (DA) numérique/analogique sont reliés à une ligne de mot pour la transmission d'une grandeur de réglage.

5. Circuit amplificateur suivant la revendication 3 ou 4,
**caractérisé en ce que**
le dispositif (SE) de réglage a un registre (REG) de mémorisation d'une valeur de compensation de décalage codée numériquement.

6. Circuit amplificateur suivant l'une des revendications 3 à 5,
**caractérisé en ce que**
le convertisseur numérique/analogique a des sources (S1, S2, S3, S1X, S2X, S3X) de courant.

7. Circuit amplificateur suivant l'une des revendications 1 à 6,
**caractérisé en ce que**
le convertisseur (CP) a une hystérésis (H) qui décrit la dépendance du signe (VZ) du côté sortie en fonction de la tension (U, UX) de décalage du côté entrée.

8. Circuit amplificateur suivant l'une des revendications 1, 7,
**caractérisé en ce que**
le circuit de régulation a une unité (CU) de commande pour la formation du signal de compensation de décalage par approximation successive.
